(19) Europäisches Patentamt

European Patent Office

Office européen des brevets

(11) **EP 4 123 692 A1**

(12) **DEMANDE DE BREVET EUROPEEN**

(43) Date de publication:
25.01.2023 Bulletin 2023/04

(21) Numéro de dépôt: 22184522.5

(22) Date de dépôt: 12.07.2022

(51) Classification Internationale des Brevets (IPC):
*H01L 21/762* (2006.01)

(52) Classification Coopérative des Brevets (CPC):
**H01L 21/76256**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: 23.07.2021 FR 2107984

(71) Demandeur: **Commissariat à l'énergie atomique et aux énergies alternatives**
**75015 Paris (FR)**

(72) Inventeurs:
• **REBOH, Shay**
**38054 GRENOBLE Cedex 09 (FR)**
• **LOUP, Virginie**
**38054 GRENOBLE CEDEX 09 (FR)**

(74) Mandataire: **Brevalex**
**Tour Trinity**
**1 Bis Esplanade de La Défense**
**CS 60347**
**92035 Paris La Défense Cedex (FR)**

(54) **PROCEDE DE FABRICATION D'UN SUBSTRAT SEMI-CONDUCTEUR SUR ISOLANT DE TYPE SOI OU SIGEOI PAR BESOI ET STRUCTURE POUR FABRIQUER UN TEL SUBSTRAT**

(57) Procédé de fabrication d'un substrat semi-conducteur sur isolant par BESOI comprenant les étapes suivantes :

a) fournir une structure comprenant un premier substrat (110), une première couche d'arrêt (111) en SiGe ayant un pourcentage atomique en Ge inférieur ou égal à 30%, une couche intermédiaire (112), une deuxième couche d'arrêt (113) en SiGe ayant une épaisseur inférieure à l'épaisseur de la première couche d'arrêt et un pourcentage atomique en Ge supérieur ou égal à 20%, éventuellement une zone active formée d'une couche en silicium (114) ou d'un empilement de couches actives en Si et SiGe, une couche diélectrique (121), un deuxième substrat (120),

b) amincir puis graver le premier substrat (110) en silicium, depuis la première face principale jusqu'à la deuxième face principale,

c) retirer successivement la première couche d'arrêt (111), la couche intermédiaire (112), et éventuellement la deuxième couche d'arrêt (113) pour obtenir un substrat SOI ou SiGeOI.

FIG.4F

**Description**

**DOMAINE TECHNIQUE**

La présente invention se rapporte au domaine général des substrats semi-conducteur-sur-isolant par exemple de type SOI ou SiGeOI.

L'invention concerne un procédé de fabrication d'un substrat semi-conducteur-sur-isolant par BESOI.

L'invention concerne également une structure pour fabriquer un substrat semi-conducteur-sur-isolant par BESOI.

L'invention trouve des applications dans de nombreux domaines industriels, et notamment pour l'intégration 3D.

L'invention est particulièrement intéressante puisqu'elle permet de fabriquer des substrats SOI, et notamment des substrats de type FDSOI, à basse température.

**ÉTAT DE LA TECHNIQUE ANTÉRIEURE**

Il existe plusieurs procédés pour fabriquer un substrat de type silicium sur isolant ('Silicon on Insulator' ou SOI).

L'un des procédés consiste à implanter de l'hydrogène dans un substrat de silicium. Le substrat est ensuite collé par adhésion moléculaire sur un autre substrat, puis on réalise un traitement thermique à une température typiquement supérieure à 400°C pour induire une fracture au niveau de la zone implantée avec hydrogène. Cette fracture cause la séparation de l'assemblage de substrats collés, au niveau de la zone implantée avec hydrogène. On obtient ainsi un substrat SOI. Cependant, un tel budget thermique n'est pas compatible avec toutes les technologies. De plus, les substrats SOI obtenus par un procédé de type Smart-Cut® doivent ensuite être soumis :

- à une étape d'amincissement par oxydation thermique suivie du retrait de l'oxyde et/ou à un procédé à haute température (typiquement à plus de 1000°C) pour éliminer la rugosité de surface résiduelle du procédé de fracture, et
- à une étape de recuit à haute température (typiquement à une température supérieure à 900°C) pour éliminer des défauts d'implantation.

Cependant, un tel budget thermique n'est pas compatible avec toutes les technologies.

Afin de remédier à cet inconvénient, il est possible de fabriquer un substrat SOI avec un procédé de type BESOI (« Bonded and Etch back Silicon On Insulator »).

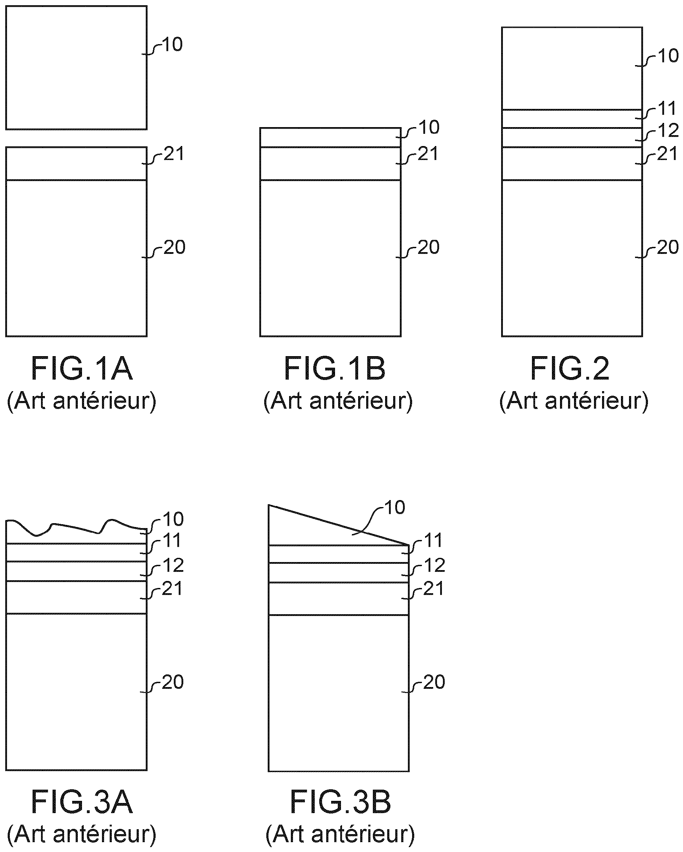

Ce procédé consiste à coller deux substrats 10, 20 de silicium : un substrat donneur 10 et un substrat de manipulation 20. Le substrat de manipulation 20 est recouvert par une couche d'oxyde 21 (Fig. 1A). Le substrat donneur 10 est ensuite aminci jusqu'à obtenir une couche active de silicium de l'épaisseur désirée, typiquement de 100 nm à quelques micromètres (Fig. 1B). Alternativement, il est possible d'avoir la couche d'oxyde sur le substrat donneur 10 ou à la fois sur le substrat donneur 10 et sur le substrat de manipulation 20. L'un des principaux avantages de cette technologie est la mise en œuvre d'un collage à faible budget thermique : un collage à 300°C peut être suffisant pour obtenir les propriétés requises.

Cependant, l'un des enjeux actuels est d'obtenir des substrats SOI ayant une très fine couche active de silicium, notamment de l'ordre de la dizaine de nanomètres voire moins et avec une très faible variabilité de cette épaisseur sur la tranche (« wafer »), typiquement inférieure à 10% de l'épaisseur de la couche active

Pour déterminer avec précision la fin de l'étape d'amincissement d'un procédé BESOI, il est possible d'utiliser une couche d'arrêt 11 (Fig. 2). On forme sur le substrat de manipulation 10, la couche d'arrêt 11 puis la couche active de silicium d'épaisseur désirée. Les deux substrats 10, 20 sont ensuite fixés l'un à l'autre. On amincit le substrat 10 jusqu'à la couche d'arrêt 11 puis on élimine cette couche d'arrêt 11. On obtient alors un substrat SOI avec une fine couche active.

Par exemple, le document US 5,013,681 décrit un procédé de fabrication d'un substrat SOI par BESOI avec une ou deux couches d'arrêt. L'une des couches d'arrêt peut être en SiGe. Le procédé avec une couche d'arrêt comporte par exemple les étapes suivantes :

- former une couche d'arrêt en un alliage de silicium et de germanium, par exemple par dépôt chimique en phase vapeur (CVD) ou épitaxie par jets moléculaire (MBE) à une température de 400°C à 900°C, sur un premier substrat de silicium, la couche d'arrêt ayant une épaisseur comprise entre 10 nm et 500 nm,
- former une couche de silicium ayant une épaisseur comprise entre 20 nm et 1 $\mu$m, sur la couche d'arrêt à une température de 400°C à 900°C, puis l'oxyder pour obtenir une couche d'oxyde en surface,
- coller l'empilement ainsi obtenu sur un deuxième substrat de silicium recouvert par une couche d'oxyde, la température de recuit étant comprise entre 700°C et 1000°C,
- polir, par exemple par CMP, le premier empilement, jusqu'à la couche d'arrêt, puis retirer la couche d'arrêt par exemple par gravure.

Cependant, ce document est muet quant à la manière de choisir l'épaisseur des couches.

Or, l'étape d'amincissement du substrat donneur est généralement réalisée par rodage mécanique ('grinding') afin de retirer rapidement une grande quantité de matière du substrat donneur 10 et ainsi obtenir rapidement des épaisseurs raisonnables pour la suite du procédé. Cette étape conduit localement à des variations d'épaisseur (Fig. 3A). Cette inhomogénéité peut être caractérisée par la variation d'épaisseur totale (nommée par la suite TTV pour 'Thickness Total Variation'). Elle peut être représentée schématiquement par une pente (comme sur la figure 3B). De plus, même si par la suite, le retrait de matière est réalisé par gravure chimique et/ou par polissage mécano-chimique (CMP), la TTV peut être légèrement réduite mais ces inhomogénéités subsistent.

Ainsi, lorsqu'à l'étape d'amincissement on atteint la couche d'arrêt, nous définissons la variation d'épaisseur due à l'amincissement/gravure du silicium par TTV arrivée (ou 'TTV landing'). La fonction de la couche d'arrêt est de réduire cette variation d'épaisseur d'arrivée. Une couche d'arrêt idéalement parfaite réduira la TTV arrivée à zéro. Néanmoins, dans la plupart des cas pratiques une variation d'épaisseur est transférée à la couche d'arrêt et définie comme TTV transférée. La couche d'arrêt 11 doit donc avoir une épaisseur minimale de préférence au moins égale au TTV transféré pour que la variation d'épaisseur due à la gravure du substrat en silicium 10 soit 'absorbée' dans la couche d'arrêt 11 et ne se propage pas à la couche active 12 sous-jacente en silicium (Fig. 3A et 3B).

Avec les machines d'amincissement ('grinding') les plus récentes, l'enlèvement de matière peut être assez homogène et la TTV est assez faible (typiquement inférieure ou égale à 1000 nm par exemple de l'ordre de 500 nm). Une seule couche d'arrêt peut être suffisante pour fabriquer un substrat SOI par BESOI avec des épaisseurs et variations d'épaisseurs faibles de la couche transférée.

Mais pour de nombreuses machines, notamment pour des machines moins couteuses et/ou pour des machines d'anciennes générations, la première étape d'amincissement peut conduire à des TTV élevées (typiquement supérieures ou égales à 2000nm voire supérieures ou égales à 2500nm). Une seule couche d'arrêt n'est alors plus suffisante. Il est alors nécessaire d'avoir une structure avec plusieurs couches d'arrêt.

Cependant, le choix de la nature et de l'épaisseur de ces couches d'arrêt n'est pas évident car il faut prendre en compte de nombreux paramètres comme l'épaisseur critique de relaxation plastique des couches d'arrêt et l'épaisseur totale de la structure qui doit rester dans un état pseudomorphique.

## EXPOSÉ DE L'INVENTION

Un but de la présente invention est de proposer un procédé de fabrication d'un substrat semi-conducteur-sur-isolant, par exemple Silicium sur isolant (SOI) ou SiGe sur isolant (SiGeOI), par BESOI remédiant au moins en partie aux inconvénients de l'art antérieur, pouvant être mis en œuvre dans de nombreuses machines d'amincissement, même les moins performantes (pouvant conduire à des TTV supérieures ou égales à 2000nm voire supérieures ou égales à 2500nm), et permettant de fabriquer un substrat SOI ayant à l'issue du procédé une couche de silicium active de bonne qualité.

Pour cela, la présente invention propose un procédé de fabrication d'un substrat semi-conducteur sur isolant, notamment un substrat de type silicium-sur-isolant ou SiGe sur isolant, par BESOI comprenant les étapes suivantes :

a) fournir une structure comprenant :

- un premier substrat en silicium, comprenant une première face principale et une seconde face principale,
- une première couche d'arrêt en SiGe ayant une première épaisseur et un pourcentage atomique en Ge inférieur ou égal à 30%, de préférence compris entre 10% et 30% et encore plus préférentiellement entre 15% et 30%, la première couche d'arrêt étant en contact avec la seconde face principale du premier substrat,
- une couche intermédiaire en silicium ou en SiGe, le pourcentage atomique en Ge de la couche intermédiaire étant inférieur d'au moins 10% voire d'au moins 15 % au pourcentage atomique en Ge de la première couche d'arrêt,
- une deuxième couche d'arrêt en SiGe ayant une deuxième épaisseur inférieure à la première épaisseur de la première couche et un pourcentage atomique en Ge supérieur ou égal à 20%, le pourcentage atomique en Ge de la couche intermédiaire étant inférieur d'au moins 10 % voire d'au moins 15 % au pourcentage atomique en Ge de la deuxième couche d'arrêt,
- éventuellement, une zone active formée d'une couche active en silicium ou d'un empilement de couches actives comprenant au moins une couche en silicium et au moins une couche en SiGe ayant de préférence un pourcentage atomique en Ge compris entre 20 % et 35 %,
- une couche diélectrique par exemple en oxyde de silicium ou en nitrure de silicium,
- un deuxième substrat par exemple en silicium.

b) amincir le premier substrat en silicium, depuis la première face principale, de manière à retirer une première partie du premier substrat et à laisser une deuxième partie du substrat, la deuxième partie ayant, par exemple, une épaisseur inférieure ou égale à 50$\mu$m, par exemple entre 30 et 50$\mu$m, de préférence inférieure ou égale à 30$\mu$m, par exemple entre 20 et 30$\mu$m, encore plus préférentiellement inférieure ou égale à 20$\mu$m, par exemple entre 10 et 20$\mu$m, de manière encore plus préférentielle inférieure ou égale à 10$\mu$m, par exemple entre 2,5 et 10$\mu$m, l'étape b) d'amincissement pouvant conduire à une variation d'épaisseur totale du premier substrat aminci supérieure ou égale à 2000nm, et de préférence supérieure ou égale à 2500nm,

c) retirer successivement :

- la deuxième partie du premier substrat, par exemple, par gravure chimique, jusqu'à la deuxième face principale du premier substrat, de manière à atteindre la première couche d'arrêt,
- la première couche d'arrêt, par exemple par gravure chimique,
- la couche intermédiaire, par exemple par gravure chimique,
- éventuellement, la deuxième couche d'arrêt, par exemple par gravure chimique, moyennant quoi on obtient un substrat semi-conducteur sur isolant comprenant un substrat recouvert par une couche diélectrique et une zone active ou un substrat recouvert par une couche diélectrique et la deuxième couche d'arrêt en SiGe.

L'invention se distingue fondamentalement de l'art antérieur par l'utilisation d'une structure comprenant deux couches d'arrêt en SiGe. Ces couches d'arrêt ont des épaisseurs et concentrations en germanium particulières. Avec une telle structure, on obtient à l'issue du procédé par BESOI, un substrat semi-conducteur sur isolant par exemple SOI ou SiGeOI de très bonne qualité. En particulier, le substrat SOI a une couche active de silicium ayant une très faible variation d'épaisseur totale induite par le procédé (TTV pour 'Total Thickness Variation') pouvant descendre à l'échelle sub-nanométrique. Ainsi, la couche active peut être très fine (typiquement avec une épaisseur inférieure ou égale à 10 nm).

Une telle structure est particulièrement intéressante pour la fabrication de BESOI avancé mettant en œuvre des étapes d'amincissement avec des machines d'amincissement moins performantes et/ou moins coûteuses que celles de dernières générations. En effet, cette structure permet de compenser des TTV de 2000 nm ou plus voire de 2500 nm ou plus.

Avantageusement, la première couche d'arrêt a un pourcentage atomique en Ge inférieur ou égal à 25%, et de préférence supérieur ou égal à 20%.

Avantageusement, la deuxième couche d'arrêt a un pourcentage atomique en Ge supérieur ou égal à 20%, et de préférence inférieur ou égal à 40%.

La première couche d'arrêt et la deuxième couche d'arrêt peuvent avoir des concentrations en Ge identiques ou différentes. Par exemple, les deux couches d'arrêt peuvent avoir une concentration en Ge de 20%.

Avantageusement, la deuxième épaisseur est au moins deux fois inférieure à la première épaisseur. La deuxième épaisseur est par exemple de 5 à 10 fois inférieure à la première épaisseur. De manière encore plus avantageuse, la deuxième épaisseur est au moins 10 fois inférieure à la première épaisseur.

De préférence, la deuxième épaisseur est inférieure ou égale à 20 nm.

La première couche d'arrêt présente une épaisseur, par exemple, inférieure à 200 nm. Avantageusement, la première couche d'arrêt a une épaisseur entre 50 nm et 150 nm, par exemple 70-80 nm, et une concentration atomique en Ge de 25%.

Avantageusement, la deuxième couche d'arrêt a une épaisseur inférieure ou égale à 20nm (sous l'épaisseur critique). De préférence, elle a une épaisseur entre 8 nm et 20 nm, par exemple 10nm, et une concentration atomique en Ge de 30 à 40%, par exemple 40%. La deuxième couche d'arrêt, ayant une forte concentration en Ge, peut être très fine. L'utilisation de couches d'arrêt de faibles épaisseurs est avantageuse d'un point vue économique mais aussi pour réduire la dégradation de la TTV introduite par le procédé d'épitaxie et minimiser le risque de formation des dislocations (épaisseur critique).

Avantageusement, la couche intermédiaire et/ou la couche active en silicium ont une épaisseur entre 5 nm et 100 nm, de préférence de 10 à 20 nm, par exemple 10 nm.

L'épaisseur de la couche intermédiaire en silicium est choisie de manière à obtenir une structure ayant une épaisseur inférieure à l'épaisseur critique de la structure pour maintenir le multicouche dans un état pseudomorphique. Le choix d'une faible épaisseur est également avantageux pour minimiser le coût de production. Il est également avantageux de réduire l'épaisseur de la couche épitaxiale pour réduire la TTV. D'un autre côté, une couche intermédiaire de plus forte épaisseur permet de compenser la contrainte de la couche de SiGe.

Avantageusement, la structure fournie à l'étape a) est obtenue selon les étapes suivantes :

i) fournir un premier empilement comprenant :

- un premier substrat de silicium,
- une première couche d'arrêt en SiGe ayant une première épaisseur et un pourcentage atomique en Ge inférieur ou égal à 30%, de préférence compris entre 10% et 30% et encore plus préférentiellement entre 15% et 30%,
- une couche intermédiaire en silicium ou en SiGe, le pourcentage atomique en Ge de la couche intermédiaire étant inférieur d'au moins 10% voire d'au moins 15 % au pourcentage atomique en Ge de la première couche d'arrêt,
- une deuxième couche d'arrêt en SiGe ayant une deuxième épaisseur inférieure à la première épaisseur de la première couche et un pourcentage atomique en Ge supérieur ou égal à 20%, le pourcentage atomique en Ge de la couche intermédiaire étant inférieur d'au moins 10% au pourcentage atomique en Ge de la deuxième couche d'arrêt,
- éventuellement une zone active formée d'une couche active en silicium ou d'un empilement de couches actives comprenant au moins une couche en silicium et au moins une couche en SiGe ayant de préférence un pourcentage atomique en Ge compris entre 20 % et 35 %,

ii) fournir un deuxième empilement comprenant un deuxième substrat, par exemple, en silicium, recouvert par une couche diélectrique par exemple en oxyde de silicium,

iii) fixer le premier empilement sur le deuxième empilement, de manière à avoir a couche diélectrique en contact avec la deuxième couche d'arrêt ou avec la zone active le cas échéant.

Le procédé de fabrication de la structure peut notamment être réalisé à basse température (typiquement inférieure à 500°C et de préférence inférieure ou égale à 300°C, voire même inférieure ou égale à 200°C).

Le procédé présente de nombreux avantages :

- ne pas utiliser de bore pour la couche d'arrêt, ce qui évite de contaminer le silicium,
- fabriquer des substrats SOI ('wafer SOI') avec un faible budget thermique (avec un collage à 200°C, on obtient un collage de 4 J/m$^2$ pour une interface Si/SiO$_2$) et sans avoir les inconvénients liés à l'implantation d'ions, par exemple la présence de défauts dans les couches transférées,
- pouvoir fabriquer un substrat SOI ayant une fine couche active compatible avec les spécifications d'une technologie FDSOI ('Fully Depleted Silicon on Insulator'), obtenue classiquement par un procédé de type Smart-Cut®,
- permettre l'intégration sur un substrat contenant des circuits sensibles aux températures élevées.

L'invention concerne également une structure pour fabriquer un substrat semi-conducteur silicium-sur isolant comprenant :

- un premier substrat de silicium,
- une première couche d'arrêt en SiGe ayant une première épaisseur et un pourcentage atomique en Ge inférieur ou égal à 30%, de préférence compris entre 10% et 30% et encore plus préférentiellement entre 15% et 30%,
- une couche intermédiaire en silicium ou en SiGe, le pourcentage atomique en Ge de la couche intermédiaire étant inférieur d'au moins 10% voire d'au moins 15 % au pourcentage atomique en Ge de la première couche d'arrêt,
- une deuxième couche d'arrêt en SiGe ayant une deuxième épaisseur inférieure à la première épaisseur de la première couche et un pourcentage atomique en Ge supérieur ou égal à 20%, le pourcentage atomique en Ge de la couche intermédiaire étant inférieur d'au moins 10 % voire d'au moins 15 % au pourcentage atomique en Ge de la deuxième couche d'arrêt,
- éventuellement, une zone active formée d'une couche active en silicium ou d'un empilement de couches actives comprenant au moins une couche en silicium et au moins une couche en SiGe ayant de préférence un pourcentage atomique en Ge compris entre 20 % et 35 %,

- une couche diélectrique par exemple en oxyde de silicium,
- un deuxième substrat par exemple en silicium.

De préférence, la deuxième épaisseur est inférieure ou égale à 20 nm.

Une telle structure est pseudomorphe.

Avantageusement, la structure comprend :

- un premier substrat de silicium,
- une première couche d'arrêt en SiGe ayant une épaisseur entre 50 nm et 150 nm et une concentration atomique en Ge de 20% à 25%,
- une couche intermédiaire en silicium,
- une deuxième couche d'arrêt en SiGe ayant une épaisseur entre 8 nm et 20 nm, par exemple 10nm, et une concentration atomique en Ge de 20% à 40%,
- une couche active en silicium,
- une couche d'oxyde de silicium,
- un deuxième substrat de silicium.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

Les figures 1A et 1B précédemment décrites, représentent de manière schématique et en coupe différentes étapes d'un procédé de fabrication d'un substrat SOI par BESOI selon l'art antérieur.

La figure 2 précédemment décrite, représente de manière schématique et en coupe, une structure pour obtenir un substrat SOI par BESOI, la structure comportant une couche d'arrêt, selon l'art antérieur.

Les figures 3A et 3B, précédemment décrites, représentent de manière schématique et en coupe, des variations d'épaisseurs après amincissement d'un substrat en silicium dans une structure comprenant une couche d'arrêt, selon l'art antérieur.

Les figures 4A à 4G représentent de manière schématique et en coupe différentes étapes d'un procédé de fabrication d'un substrat SOI par BESOI selon un mode de réalisation particulier de l'invention.

La figure 5 est un graphique représentant la TTV transférée en fonction de la TTV d'arrivée ('TTV landing') pour des couches d'arrêt en SiGe de différentes concentrations, les lignes horizontales représentent les épaisseurs critiques de couches d'arrêt en SiGe à 20, 30 et 40%,.

La figure 6 est un graphique représentant la TTV transférée au niveau des interfaces d'une structure avec deux couches d'arrêt en SiGe, pour différentes concentrations en Ge, et pour une TTV d'arrivée ('TTV landing') de 500nm.

La figure 7 est un graphique représentant la TTV transférée au niveau des interfaces d'une structure avec deux couches d'arrêt en SiGe, pour différentes concentrations en Ge, et pour une TTV d'arrivée ('TTV landing') de 2000nm.

La figure 8 est un graphique représentant la TTV transférée au niveau des interfaces d'une structure avec deux couches d'arrêt en SiGe, pour différentes TTV d'arrivée ('TTV landing'), et pour une concentration en Ge de 20%.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous », etc., d'une structure s'appliquent en considérant que la structure est orientée de la façon illustrée sur les figures.

## EXPOSÉ DÉTAILLÉ DE MODES DE RÉALISATION PARTICULIERS

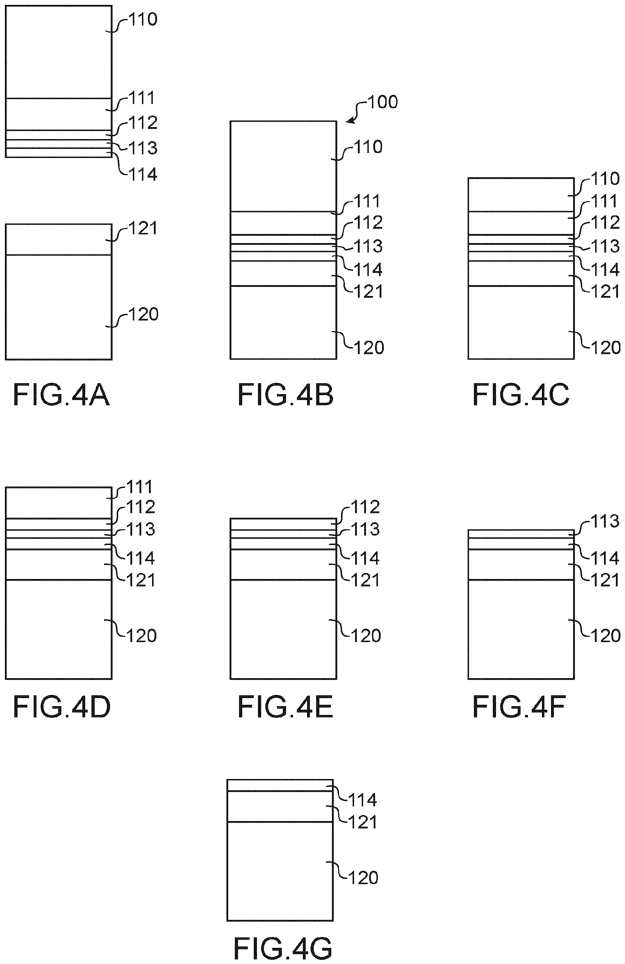

On se réfère tout d'abord aux figures 4A à 4G qui représentent différentes étapes d'un procédé de fabrication d'un substrat SOI par BESOI. Le procédé comprend les étapes suivantes :

a) fournir une structure 100 multi-couches à amincir, obtenue par exemple, selon les sous-étapes i), ii) et iii) suivantes :

i) fournir un premier empilement comprenant successivement :

- un premier substrat de silicium 110 (dit substrat donneur) comprenant une première face principale et une deuxième face principale,
- une première couche d'arrêt 111 en SiGe ayant une première épaisseur et un pourcentage atomique en Ge inférieur ou égal à 30%, de préférence compris entre 10% et 30% et encore plus préférentiellement entre 15% et 30%,
- une couche intermédiaire 112 en silicium ou en SiGe,
- une deuxième couche d'arrêt 113 en SiGe ayant une deuxième épaisseur inférieure à la première épaisseur de la première couche et un pourcentage atomique en Ge supérieur ou égal à 20%,
- éventuellement une zone active formée d'une couche active (114) en silicium (Fig. 4A) ou d'un empilement de couches actives formé d'au moins une couche en silicium et d'au moins une couche en SiGe ayant de préférence un pourcentage atomique en Ge entre 20 % et 35 %,

ii) fournir un deuxième empilement comprenant un deuxième substrat par exemple en silicium 120 (dit substrat de manipulation) recouvert par une couche diélectrique 121 par exemple en oxyde de silicium ou en nitrure de silicium (Fig. 4A),

iii) fixer le premier empilement sur le deuxième empilement, la couche diélectrique 121 étant en contact avec la zone active ou avec la deuxième couche d'arrêt 113 (Fig. 4B),

b) amincir progressivement le premier substrat 110 en silicium, depuis la première face principale de ce substrat, de manière à retirer une première partie du premier substrat 110 et à laisser une deuxième partie du substrat 110, la deuxième partie ayant, par exemple, une épaisseur inférieure entre 30 et 50$\mu$m, de préférence entre 20 et 30$\mu$m, encore plus préférentiellement entre 10 et 20$\mu$m, de manière encore plus préférentielle entre 2,5 et 10$\mu$m, l'étape d'amincissement pouvant conduire à une variation totale d'épaisseur supérieure ou égale à 2000nm, et de préférence supérieure ou égale à 2500nm, (Fig. 4C),

c) retirer successivement :

- la deuxième partie du premier substrat 110, par exemple, par gravure chimique, jusqu'à la deuxième face principale du premier substrat 110, de manière à atteindre la première couche d'arrêt 111 (Fig. 4D),
- la première couche d'arrêt 111 (Fig. 4E),
- la couche intermédiaire 112 (Fig. 4F),
- éventuellement, la deuxième couche d'arrêt 113, moyennant quoi on obtient un substrat semi-conducteur sur isolant comprenant un substrat 120 recouvert par une couche diélectrique 121 et une zone active ou un substrat 120 recouvert par une couche diélectrique 121 et la deuxième couche d'arrêt en SiGe 113 (Fig. 4G).

Lorsque la deuxième couche d'arrêt 113 est retirée et que le premier empilement comprend une zone active, notamment une couche active en silicium 114, on obtient un substrat de type SOI.

Lorsque la deuxième couche d'arrêt 113 n'est pas retirée et que le premier empilement ne comprend pas de zone active, on obtient un substrat de type Si-GeOI. La deuxième couche d'arrêt 113 joue alors également le rôle de couche active.

Le premier empilement fourni à l'étape i) comprend un premier substrat 110, deux couches d'arrêt de gravure 111, 113 (ESL pour 'etch stopping layer'), une couche intermédiaire 112 et éventuellement une zone active.

Le premier substrat 110 comprend deux faces principales : une première face principale et une deuxième face principale.

La première couche d'arrêt 111 est en contact avec la deuxième face principale du premier substrat 110.

La première couche d'arrêt 111 a une épaisseur permettant d'absorber la variation d'épaisseur résultant de l'étape d'amincissement et/ou l'étape de gravure du premier substrat 110.

La deuxième couche d'arrêt 113 a une épaisseur permettant d'absorber la variation d'épaisseur résultant de la gravure de la couche intermédiaire 112.

Ces épaisseurs sont, avantageusement, compatibles avec l'épaisseur critique de relaxation plastique afin d'éviter la formation de dislocations. D'une manière générale, on choisira une épaisseur la plus faible possible pour minimiser la dégradation de la TTV due à l'épitaxie et/ou à l'étape de gravure. Les épaisseurs des couches du premier empilement dépendent également des sélectivités lors de la gravure. Plus une sélectivité sera grande, plus l'épaisseur de la couche d'arrêt pourra être faible.

De préférence, la deuxième épaisseur est au moins deux fois inférieure à la première épaisseur, et encore plus préférentiellement, la deuxième épaisseur est au moins 10 fois inférieure à la première épaisseur.

De préférence, la première couche d'arrêt 111 a un pourcentage atomique en Ge supérieur ou égal à 20% et/ou inférieur ou égal à 25%.

De préférence, la deuxième couche d'arrêt 113 a un pourcentage atomique en Ge supérieur ou égal à 20% et/ou inférieur ou égal à 40%.

Par exemple, la première couche d'arrêt 111 a une épaisseur entre 50 nm et 150 nm et une concentration atomique en Ge de 25%.

Par exemple, la deuxième couche d'arrêt 113 a une épaisseur entre 5 nm et 20 nm, par exemple 10 nm, et une concentration atomique en Ge de 40%.

Les épaisseurs de la première couche d'arrêt 111 et de la deuxième couche d'arrêt 113 respectent, avantageusement, le critère de l'épaisseur critique de relaxation plastique détaillée, par exemple, dans l'article de Hartmann et al. (J. Appl. Phys. 110, 083529 (2011)).

La couche intermédiaire 112 permet d'absorber la variation d'épaisseur. La couche intermédiaire est en Si ou en SiGe.

Le pourcentage atomique en Ge de la couche intermédiaire est inférieur d'au moins 10 % voire d'au moins 15 % au pourcentage atomique en Ge de la première couche d'arrêt.

Le pourcentage atomique en Ge de la couche intermédiaire étant inférieur d'au moins 10% voire d'au moins 15 % au pourcentage atomique en Ge de la deuxième couche d'arrêt.

De tels pourcentages permettent d'avoir une bonne sélectivité entre la couche intermédiaire et les couches d'arrêt.

Lors de la gravure de la couche supérieure, la couches d'arrêt n'est pas ou peu gravée ce qui permet d'arrêter la gravure grâce à une différence de sélectivité de gravure.

La zone active peut être formée d'une couche active en silicium 114 ou d'un empilement dit actif de couches actives. L'empilement de couches actives comprend au moins une couche en silicium et au moins une couche en SiGe. En particulier, l'empilement comprend au moins deux couches. Il peut comprendre plus de 2 couches, par exemple de 3 à 21 couches. L'empilement est formé d'une alternance de couches en Si et de couches en SiGe. Par exemple, il peut contenir 10 couches en Si.

Le pourcentage atomique de la couche ou des couches de SiGe de l'empilement est compris entre 20 % et 35 %, de préférence entre 20 % et 30 %.

La couche intermédiaire 112 et/ou la couche active 114 en silicium ont, de préférence, une épaisseur entre 5 nm et 30 nm, par exemple 10-20 nm.

Pour obtenir ce premier empilement fourni à l'étape i), on forme sur le premier substrat de silicium 110, la première couche d'arrêt en SiGe 111, la couche intermédiaire 112, la deuxième couche d'arrêt 113 en SiGe et finalement la zone active. Ces couches sont formées de préférence par épitaxie.

Le deuxième empilement fourni à l'étape ii) comprend une couche diélectrique 121, notamment une couche d'oxyde qui peut être formée sur le deuxième substrat 120 par oxydation thermique. La couche diélectrique 121 peut avoir une épaisseur de 10 à 1000 nm. La couche diélectrique 121 joue le rôle de couche de collage.

Alternativement, le premier empilement comprend une couche diélectrique. Selon une autre alternative, le premier empilement comprend une première couche diélectrique et le deuxième empilement comprend une deuxième couche diélectrique.

Les deux empilements sont fixés l'un à l'autre (étape iii), de préférence par collage moléculaire. A l'issue de l'étape iii), la deuxième couche d'arrêt 113 est positionnée entre la couche diélectrique 121 et la couche intermédiaire 112.

La structure ainsi obtenue comprend successivement :

- un premier substrat de silicium 110,

- une première couche d'arrêt 111 en SiGe ayant une première épaisseur et un pourcentage atomique en Ge inférieur ou égal à 30%, de préférence compris entre 10% et 30% et encore plus préférentiellement entre 15% et 30%, l'épaisseur de la première couche respectant avantageusement le critère de l'épaisseur critère,
- une couche intermédiaire 112,
- une deuxième couche d'arrêt en SiGe 113, ayant une deuxième épaisseur inférieure la première épaisseur de la première couche,
- éventuellement une zone active par exemple une couche active en silicium 114,
- une couche diélectrique 121,
- un deuxième substrat par exemple en silicium 120.

De préférence, la deuxième épaisseur est inférieure ou égale à 20 nm.

Les couches croissent avec le paramètre de maille de la structure sous-jacente. L'épaisseur des couches (couches d'arrêt de gravure et couche intermédiaire) sont choisies de sorte à maintenir la structure dans un état pseudomorphique.

À titre illustratif et non limitatif, selon une variante de réalisation, la structure peut comprendre :

- un premier substrat de silicium 110,
- une première couche d'arrêt 111 en SiGe de 80 nm ayant un pourcentage atomique en Ge de 25%,
- une couche intermédiaire en silicium 112 de 10 nm,
- une deuxième couche d'arrêt en SiGe 113 de 10 nm ayant un pourcentage atomique en Ge de 40%,
- une couche active en silicium 114 de 10 nm,
- une couche d'oxyde de silicium 121 de 145 nm,
- un deuxième substrat de silicium 120.

Selon une autre variante de réalisation, la structure peut comprendre :

- un premier substrat 110 de silicium,
- une première couche d'arrêt 111 en SiGe ayant une épaisseur entre 200 et 240 nm et une concentration atomique en Ge de 20%,
- une couche intermédiaire 112 en silicium de 15 à 30 nm,
- une deuxième couche d'arrêt 113 en SiGe ayant une épaisseur entre 10 nm et 20 nm, et une concentration atomique en Ge de 30%,
- une couche active en silicium 114 de 5 à 50nm,
- une couche d'oxyde de silicium 121,
- un deuxième substrat de silicium 120.

De telles structures sont stables. L'épaisseur d'une structure multicouche est définie par :

$$ESS^{thickness} = \sum_{i}^{n} t_i$$

avec ti l'épaisseur d'une couche i

Avantageusement, cette épaisseur est inférieure à l'épaisseur critique de la structure multicouche donnée dans l'article Hartmann et al. précédemment cité.

L'épaisseur critique dépend en particulier de la concentration moyenne en germanium des couches d'arrêt définie par :

$$Aver^{concGe} = \frac{\sum_{i}^{n} x_i * t_i}{\sum_{i}^{n} t_i}$$

Avec $x_i$ la concentration en germanium de la couche d'arrêt i, $t_i$ l'épaisseur de la couche d'arrêt i, i un entier (dans le cas de deux couches d'arrêt i est égal à 1 ou 2)

Lors de l'étape b), on amincit le premier substrat 110. On retire au moins une première partie du premier substrat depuis la première face principale.

De préférence, le premier substrat 110 est aminci au moins en partie, voire totalement, par amincissement par rodage mécanique aussi appelé meulage ('grinding'). Cette étape conduit à une forte variation de l'épaisseur totale du substrat aminci.

Avantageusement, le retrait du premier substrat 110 se déroule en deux sous-étapes.

On réalise, dans une première sous-étape, un amincissement par rodage mécanique pour retirer rapidement une première partie du premier substrat 110 à partir de la première face principale. Typiquement, on retire une épaisseur de quelques centaines ou dizaines de micromètres, jusqu'à une épaisseur typiquement inférieure à 30 ou 50 $\mu$m, ou inférieure à 20 ou 30$\mu$m voire même inférieure à 10 $\mu$m. On peut retirer une première partie de manière à avoir une deuxième partie dont l'épaisseur fait moins de 5 $\mu$m. Après amincissement par rodage mécanique, la variation d'épaisseur totale (TTV) à la surface du premier substrat aminci peut être supérieure ou égale à 2000nm ou supérieure ou égale à 2500nm. Elle peut également être inférieure, par exemple, la variation d'épaisseur totale (TTV) à la surface du premier substrat aminci peut être de 500nm.

Puis dans une deuxième sous-étape, on réalise un polissage mécano-chimique (CMP pour 'Chemical Mechanical Polishing') et/ou gravure chimique (par voie humide et/ou par voie sèche), permettant de retirer plus finement la deuxième partie du premier substrat 110 jusqu'à la deuxième face principale du premier substrat 110 (étape c).

Avantageusement, la deuxième sous-étape permet d'obtenir une surface sans défaut, et notamment sans rayure.

À l'issue de la deuxième sous-étape, la TTV demeure supérieure ou égale à 2000 nm voire supérieure ou égale à 2500 nm.

À l'issue de l'étape b), le premier substrat 110 a été aminci jusqu'à la seconde principale.

On appelle TTV d'arrivée ('TTV landing') la variation d'épaisseur lorsque l'on atteint la seconde face principale du premier substrat 110 en contact avec la première couche d'arrêt 111. Cette variation d'épaisseur est au moins en partie transférée à la première couche d'arrêt. On appelle TTV transférée ('TTV transferred'), la variation d'épaisseur totale transférée à la première couche d'arrêt.

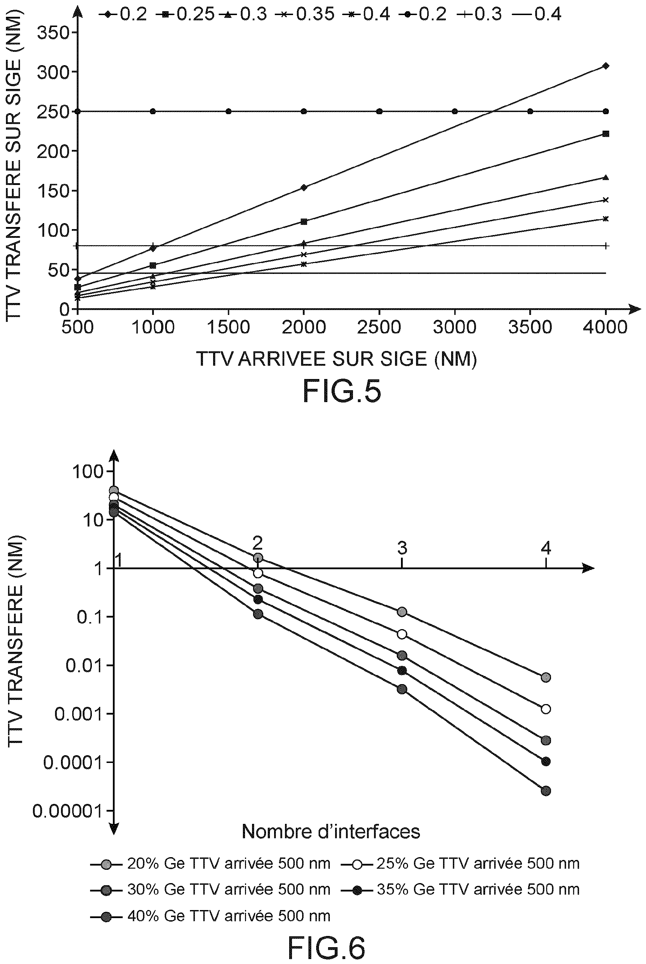

La figure 5 représente la TTV transférée à une couche d'arrêt en SiGe après le retrait d'une couche de silicium, avec une solution de TEAH, pour différents TTV d'arrivée. Ce graphique représente également les épaisseurs critiques tc pour des couches de SiGe ayant des concentrations de 20%, 30% et 40%. Cette figure permet de déterminer l'épaisseur minimale d'une couche de SiGe pour éliminer complètement du silicium par gravure et arrêter la gravure à l'intérieur de la couche de SiGe, sans la retirer complètement (autrement dit sans atteindre la couche sous-jacente).

Les valeurs des épaisseurs critiques proviennent de l'article de Hartmann et al. précédemment cité.

La figure 5 montre par exemple qu'une couche de Si avec une TTV d'arrivée de 3500 nm pourrait être gravée en utilisant une couche de SiGe pseudomorphique de 20% d'environ 240 nm. Pour une TTV d'arrivée de 2000 nm, une couche de SiGe à 30% voire même à 35% pourrait être utilisée. Cependant, les épaisseurs critiques de ces couches ne sont pas compatibles avec les concentrations nécessaires pour absorber les TTV d'arrivée.

La figure 6 représente la variation d'épaisseur transférée en fonction des interfaces d'une structure obtenue selon une séquence typique d'enlèvement Si/interface 1/SiGe/interface 2/Si/interface 3/SiGe/interface 4/Si avec une faible TTV d'arrivée ('TTV landing'), ici 500nm. Pour obtenir une TTV transférée sub-nanométrique (i.e. ayant une valeur inférieure à 1nm), une couche d'arrêt en SiGe ayant une concentration atomique d'au moins 25% est suffisante.

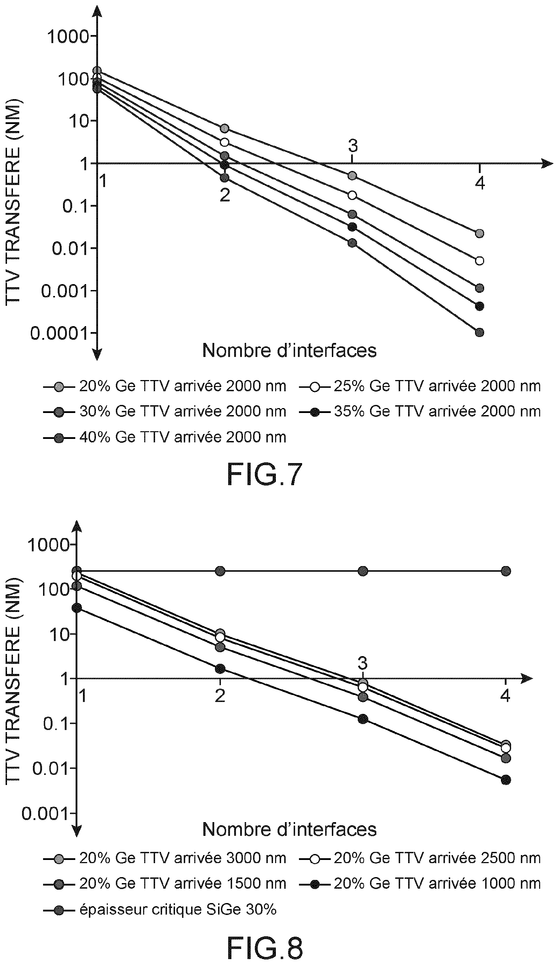

La figure 7 représente cette fois la variation d'épaisseur totale transférée en fonction des interfaces (mêmes interfaces que pour la figure 6) avec un fort TTV d'arrivée (TTV landing), ici 2000nm. Il semblerait tentant de choisir une première couche d'arrêt avec des concentrations de 30% ou 35%, mais leurs épaisseurs ne seraient pas compatibles avec les épaisseurs critiques (figure 5). Plusieurs couches d'arrêt sont donc nécessaires pour pouvoir obtenir une TTV sub-nanométrique pour la couche active.

La figure 8 représente l'évolution de la TTV transférée avec des couches d'arrêt en SiGe à 20% pour différents TTV landing (de 1000nm à 3000nm) avec les mêmes interfaces que pour la figure 6. Il ressort clairement de cette figure qu'avec une TTV d'arrivée de 3000 nm, une seule couche d'arrêt conduit à une TTV de l'ordre de 10 nm ce qui est inacceptable dans le cas d'applications microélectroniques avancées. En revanche, avec deux couches d'arrêt en SiGe à 20%, on obtient en arrivant sur la couche active une TTV introduite par le procédé d'amincissement inférieure à 1 nm.

Après l'étape c), on retire successivement les autres couches du premier empilement jusqu'à obtenir un substrat de type SOI ou SiGeOI (étape c) :

- la première couche d'arrêt 111, par une gravure sélective avec arrêt sur la couche intermédiaire,
- la couche intermédiaire 112, par une gravure sélective avec arrêt sur la deuxième couche d'arrêt, et
- éventuellement la deuxième couche d'arrêt 113 par une gravure sélective avec arrêt sur la zone active lorsqu'elle est présente.

La couche intermédiaire 112 (disposée entre les deux couches d'arrêt 111 et 113) est intégralement supprimée de sorte que l'on obtient, à l'issue de l'étape c), un substrat non processé (SOI ou SiGeOI) dans lequel on va pouvoir faire des composants.

Lors des étapes b) et c), chacun des éléments (couche ou substrat) à graver présentent, avantageusement, une sélectivité de gravure par rapport à la couche sous-jacente.

Le premier substrat 110 peut présenter une sélectivité de gravure vis-à-vis de la première couche d'arrêt 111 comprise, par exemple, entre 10 et 100, de préférence entre 10 et 50.

La première couche d'arrêt 111 peut présenter une sélectivité de vis-à-vis de la couche intermédiaire 112 comprise, par exemple, entre 10 et 500, de préférence entre 30 et 150.

Le couche intermédiaire 112 peut présenter une sélectivité de vis-à-vis de la deuxième couche d'arrêt 113 comprise, par exemple, entre 10 et 100, de préférence entre 10 et 50.

La deuxième couche d'arrêt 113 peut présenter une sélectivité de vis-à-vis de la zone active et notamment vis-à-vis de la zone active 114 comprise, par exemple, entre 10 et 500, de préférence entre 30 et 150.

Ces différentes gravures peuvent être des gravures par voie sèche ou par voie humide.

On choisira une solution de gravure anisotrope du silicium, notamment une solution de TMAH (Hydroxyde de Tétraméthylammonium), TEAH (Hydroxyde de Tétraéthylammonium), KOH, ou $NH_4OH$.

A titre illustratif, le silicium est retiré par gravure humide avec une solution diluée, par exemple, entre 2% et 10% et de préférence à 6% de TEAH à une température par exemple entre 60°C et 90°C. Alternativement, il est possible d'utiliser une solution de TMAH à 5 % par exemple à 60°C. On pourra également choisir une solution d"ammoniaque dilué de 1 à 5%, par exemple 4%, à 60°C.

Le silicium peut être aussi retiré par une gravure sèche, notamment une gravure par plasma type fluoré.

La première couche d'arrêt 111 et/ou la deuxième couche d'arrêt 113 sont avantageusement retirées par gravure par voie humide.

La solution de gravure du SiGe est, par exemple un mélange acide acétique/HF/$H_2O_2$, une solution SC1 (mélange d'ammoniaque $NH_4OH$, de peroxyde d'hydrogène $H_2O_2$ et d'eau) à température ambiante ou à chaud, une solution de $H_2O_2$ à 5% à chaud (par exemple à 60°C), une solution d'acide sulfurique à chaud (par exemple à 180°C), une solution de SPM (« Sulfuric peroxide mixture »), une solution CARO, une solution Piranha (un mélange d'acide sulfurique par exemple chauffé à 180°C et d'eau oxygénée).

**Revendications**

1. Procédé de fabrication d'un substrat semi-conducteur sur isolant par BESOI comprenant les étapes suivantes :

   a) fournir une structure comprenant successivement :

   - un premier substrat (110) en silicium, comprenant une première face principale et une seconde face principale,
   - une première couche d'arrêt (111) en SiGe ayant une première épaisseur et un pourcentage atomique en Ge inférieur ou égal à 30%, et de préférence compris entre 10% et 30%, la première couche d'arrêt (111) étant en contact avec la seconde face principale du premier substrat (110),
   - une couche intermédiaire (112) en silicium ou en SiGe, le pourcentage atomique en Ge de la couche intermédiaire étant inférieur d'au moins 10% au pourcentage atomique en Ge de la première couche d'arrêt (111),
   - une deuxième couche d'arrêt (113) en SiGe ayant une deuxième épaisseur inférieure ou égale à 20 nm, la deuxième épaisseur étant inférieure à la première épaisseur de la première couche, la deuxième couche d'arrêt (113) ayant un pourcentage atomique en Ge supérieur ou égal à 20%, le pourcentage atomique en Ge de la couche intermédiaire étant inférieur d'au moins 10 % au pourcentage atomique en Ge de la deuxième couche d'arrêt (113),
   - éventuellement, une zone active formée d'une couche active en silicium (114) ou d'un empilement de couches actives comprenant au moins une couche en silicium et au moins une couche en SiGe ayant de préférence un pourcentage atomique en Ge compris entre 20 % et 35 %,
   - une couche diélectrique par exemple en oxyde de silicium (121),
   - un deuxième substrat par exemple en silicium (120),

   b) amincir le premier substrat (110) en silicium, depuis la première face principale, de manière à retirer une première partie du premier substrat et à laisser une deuxième partie du substrat, la deuxième partie ayant, par exemple, une épaisseur inférieure ou égale à 50$\mu$m,
   c) retirer successivement :

   - la deuxième partie du premier substrat (110), par exemple, par gravure chimique, jusqu'à la deuxième face principale du premier substrat (110), de manière à atteindre la première couche d'arrêt (111),
   - la première couche d'arrêt (111), par exemple par gravure chimique,
   - la couche intermédiaire (112), par exemple par gravure chimique,
   - éventuellement, la deuxième couche d'arrêt (113), par exemple par gravure chimique, moyennant quoi on obtient un substrat semi-conducteur sur isolant comprenant un substrat (120) recouvert par une couche diélectrique (121) et une zone active (114) ou un substrat (120) recouvert par une couche diélectrique (121) et la deuxième couche d'arrêt en SiGe (113).

2. Procédé selon la revendication 1, **caractérisé en ce que** l'étape b) d'amincissement conduit à une variation d'épaisseur totale du premier substrat (110) aminci supérieure ou égale à 2000nm, notamment supérieure ou égale à 2500nm.

3. Procédé selon l'une des revendications 1 et 2, **caractérisé en ce que** la deuxième épaisseur est au moins deux fois inférieure à la première épaisseur et de préférence au moins 10 fois inférieure à la première épaisseur.

4. Procédé selon l'une des revendications précédentes, **caractérisé en ce que** la première couche d'arrêt (111) a un pourcentage atomique en Ge inférieur ou égal à 25%, et de préférence supérieur ou égal à 20%.

5. Procédé selon l'une quelconque des revendications précédentes, **caractérisé en ce que** la deuxième couche d'arrêt (113) a un pourcentage atomique en Ge supérieur ou égal à 20%, et de préférence inférieur ou égal à 40%.

6. Procédé selon l'une quelconque des revendications précédentes, **caractérisé en ce que** la première couche d'arrêt (111) a une épaisseur entre 50 nm et 150 nm, par exemple 120 nm, et une concentration atomique en Ge de 25%.

7. Procédé selon l'une quelconque des revendications précédentes, **caractérisé en ce que** la deuxième couche d'arrêt (113) a une épaisseur entre 8 nm et 20 nm, par exemple 10 nm, et une concentration atomique en Ge de 40%.

8. Procédé selon l'une quelconque des revendications précédentes, **caractérisé en ce que** la couche intermédiaire (112) et/ou la couche active (114) en silicium ont une épaisseur entre 5 nm et 100 nm, par exemple 10 nm.

9. Procédé selon l'une quelconque des revendications précédentes, **caractérisé en ce que** la structure fournie à l'étape a) est obtenue selon les étapes suivantes :

   i) fournir un premier empilement comprenant successivement :

   - un premier substrat de silicium (110),
   - une première couche d'arrêt (111) en SiGe ayant une première épaisseur et un pourcentage atomique en Ge inférieur ou égal à 30%, et de préférence compris entre 10% et 30%,
   - une couche intermédiaire (112) en silicium ou en SiGe, le pourcentage atomique en Ge de la couche intermédiaire (112) étant inférieur d'au moins 10% au pourcentage atomique en Ge de la première couche d'arrêt (111),
   - une deuxième couche d'arrêt (113) en SiGe ayant une deuxième épaisseur inférieure ou égale à 20 nm, la deuxième épaisseur étant inférieure à la première épaisseur de la première couche, la deuxième couche d'arrêt (113) ayant un pourcentage atomique en Ge supérieur ou égal à 20%, le pourcentage atomique en Ge de la couche intermédiaire étant inférieur d'au moins 10 % au pourcentage atomique en Ge de la deuxième couche d'arrêt (113),
   - éventuellement, une zone active formée d'une couche active en silicium (114) ou d'un empilement de couches actives comprenant au moins une couche en silicium et au moins une couche en SiGe ayant de préférence un pourcentage atomique en Ge compris entre 20 % et 35 %,

   ii) fournir un deuxième empilement comprenant un deuxième substrat (120) de silicium recouvert par une couche diélectrique (121) par exemple en oxyde de silicium,
   iii) fixer le premier empilement sur le deuxième empilement, de manière à avoir la couche diélectrique (121) en contact avec la deuxième couche d'arrêt (113) ou avec la zone active.

10. Structure (100) pour fabriquer un substrat semi-conducteur silicium-sur-isolant selon un procédé selon l'une quelconque des revendications précédentes comprenant :

   - un premier substrat (110) de silicium,
   - une première couche d'arrêt (111) en SiGe ayant une première épaisseur et un pourcentage atomique en Ge inférieur ou égal à 30%, et de préférence compris entre 10% et 30%,
   - une couche intermédiaire (112) en silicium ou en SiGe, le pourcentage atomique en Ge de la couche intermédiaire étant inférieur d'au moins 10% au pourcentage atomique en Ge de la première couche d'arrêt,
   - une deuxième couche d'arrêt (113) en SiGe ayant une deuxième épaisseur inférieure ou égale à 20 nm, la deuxième épaisseur étant inférieure à la première épaisseur de la première couche, la deuxième couche d'arrêt (113) ayant un pourcentage atomique en Ge supérieur ou égal à 20%, le pourcentage atomique en Ge de la couche intermédiaire étant inférieur d'au moins 10 % au pourcentage atomique en Ge de la deuxième couche d'arrêt (113),
   - éventuellement, une zone active formée d'une couche active (114) en silicium ou d'un empilement de couches actives comprenant au moins une couche en silicium et au moins une couche en SiGe ayant de préférence un pourcentage atomique en Ge compris entre 20 % et 35 %,
   - une couche diélectrique (121) par exemple en oxyde de silicium,
   - un deuxième substrat par exemple en silicium (120).

11. Structure selon la revendication 10, **caractérisée en ce qu'**elle comprend :

   - un premier substrat (110) de silicium,
   - une première couche d'arrêt (111) en SiGe ayant une épaisseur entre 50 nm et 150 nm et une concentration atomique en Ge de 20% à 25%,
   - une couche intermédiaire (112) en silicium,
   - une deuxième couche d'arrêt (113) en SiGe ayant une épaisseur entre 8 nm et 20 nm, par exemple 10nm, et une concentration atomique en Ge de 20% à 40%,
   - une couche active en silicium (114),
   - une couche d'oxyde de silicium (121),

- un deuxième substrat de silicium (120).

FIG.1A
(Art antérieur)

FIG.1B
(Art antérieur)

FIG.2
(Art antérieur)

FIG.3A
(Art antérieur)

FIG.3B
(Art antérieur)

FIG.4A

FIG.4B

FIG.4C

FIG.4D

FIG.4E

FIG.4F

FIG.4G

FIG.5

FIG.6

FIG.7

FIG.8

Europäisches
Patentamt

European
Patent Office

Office européen
des brevets

# RAPPORT DE RECHERCHE EUROPEENNE

Numéro de la demande

EP 22 18 4522

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 5 476 813 A (NARUSE HIROSHI [JP]) 19 décembre 1995 (1995-12-19) * ligne 1, alinéa 4 – ligne 55, alinéa 5; figures 1A-4D * ----- | 1-11 | INV. H01L21/762 |
| A | US 6 059 895 A (CHU JACK OON [US] ET AL) 9 mai 2000 (2000-05-09) * figures 1-4 * ----- | 1-11 | |
| A | WO 01/99169 A2 (MASSACHUSETTS INST TECHNOLOGY [US]) 27 décembre 2001 (2001-12-27) * page 19, ligne 19 – page 21, ligne 22; figures 11A-11F * ----- | 1-11 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 24 novembre 2022 | Ott, André |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P04C02)

## EP 4 123 692 A1

**ANNEXE AU RAPPORT DE RECHERCHE EUROPEENNE
RELATIF A LA DEMANDE DE BREVET EUROPEEN NO.**

EP 22 18 4522

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-11-2022

| Document brevet cité au rapport de recherche | | Date de publication | Membre(s) de la famille de brevet(s) | | Date de publication |
|---|---|---|---|---|---|
| US 5476813 | A | 19-12-1995 | JP | 2980497 B2 | 22-11-1999 |
| | | | JP | H07142502 A | 02-06-1995 |
| | | | US | 5476813 A | 19-12-1995 |
| US 6059895 | A | 09-05-2000 | JP | 2908787 B2 | 21-06-1999 |
| | | | JP | H10308503 A | 17-11-1998 |
| | | | KR | 19980081556 A | 25-11-1998 |
| | | | TW | 388969 B | 01-05-2000 |
| | | | US | 5906951 A | 25-05-1999 |
| | | | US | 6059895 A | 09-05-2000 |
| WO 0199169 | A2 | 27-12-2001 | AU | 6857701 A | 02-01-2002 |
| | | | EP | 1295319 A2 | 26-03-2003 |
| | | | JP | 2003536273 A | 02-12-2003 |
| | | | WO | 0199169 A2 | 27-12-2001 |

EPO FORM P0460

Pour tout renseignement concernant cette annexe : voir Journal Officiel de l'Office européen des brevets, No.12/82

**EP 4 123 692 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5013681 A

**Littérature non-brevet citée dans la description**

- **HARTMANN et al.** *J. Appl. Phys.,* 2011, vol. 110, 083529